**Europäisches Patentamt**

**European Patent Office**

**Office européen des brevets**

(19)

(11) **EP 0 973 363 A1**

(12) **EUROPEAN PATENT APPLICATION**

(43) Date of publication:
**19.01.2000 Bulletin 2000/03**

(51) Int Cl.⁷: **H05K 1/11**, H05K 1/02

(21) Application number: **99650062.5**

(22) Date of filing: **15.07.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **15.07.1998 IE 980571**

(71) Applicant: **Artesyn Technologies County Cork (IE)**

(72) Inventor: **Bardos, Peter,**
**c/o Artesyn -Technologies**
**County Cork (IE)**

(74) Representative: **O'Connor, Donal Henry**
**c/o Cruickshank & Co.,**
**1 Holles Street**
**Dublin 2 (IE)**

(54) **A conductor**

(57)    An electrical conductor (13) which is connected to the input connection (14) of a component (12) which is typically a capacitor filter or sub-circuit and which feeds other components in the circuit the conductor (13) has a break (15) in the conducting path. In the drawing the break (15) is where the conductor (13) contacts the input connection (14) but this is not essential. The conducting path is through the conductor (13) one end (17) across the input connection (14), through the other end 16 and then back into the conductor (13). The invention is particularly suited for components with low unwanted impedances and for frequencies over 20 KHz.

*Fig. 2*

EP 0 973 363 A1

## Description

The present invention relates to an electrical conductor for connection to a component input of the type which by-passes the component to connect to another component and also to an assembly of an electrical conductor and certain components.

Problems can arise in electrical and electronic circuits in ensuring that the current is correctly directed through the component. Normally, the impedance of the connection between a component and the conductor which by-passes the component is irrelevant. In certain circumstances, however, the impedance of the connection can have a relevance. For example, components can have quite low impedance, particularly with improved manufacturing techniques and their size getting smaller in many a printed circuit board, then the impedance of the connection and the contact can become significant. A typical example of this is switch mode power supplies, or other high frequency operations. For example, in a small DC/DC converter, there could be up to four hundred connections and impedance of connection might only be a matter of concern in five or six of these. Another example where this can be significant is in situations where it is desired to measure the load at particular points in a circuit where usually some signal handling device such as an ohmmeter is mounted across the main component through which the load has to be connected. In the latter case, this has often been solved by the so-called Kelvin connection, however, it remains a problem particularly in printed circuit boards. More generally the problem is to derive low level signals in a high power or frequency circuit. These two namely power and signal have to be isolated into separate paths. The problem is not of galvanic isolation, but separation. The problem is that noise of the connection is introduced into the measurement and this can be a particular problem where the measurement is used for overload protection in that the instrument is now measuring a load greater than the actual true load and this means that precautions have to be taken either by producing components that are more robust than required, or by operating the circuit below its true capacity.

However, while the above comments have been directed specifically to switch mode power supplies, where generally very high frequencies of above 20 KHz apply, it will be appreciated that similar problems can arise in other power handling situations. High frequencies in this specification mean those above 20 KHz.

Finally, as will be appreciated, as circuits become more complex and the number of components increase in such power conversion circuits among others, the unwanted noise increases and indeed noise at output is becoming more and more a problem in such circuits.

In this specification the term impedance is used generally to cover both the resistance, the capacitance, or the inductance of any conductor or component. Strictly speaking for example with a capacitor the only impedances that one would be concerned with are either the inductive or resistive components namely the unwanted impedances which cause the problem, rather than those provided by the component itself. The same applies to other components.

The present invention is directed towards providing an improved electrical conductor that will overcome some of the aforesaid problems and in particular to providing an assembly of components and a conductor which will overcome the problems.

## Statements of Invention

The invention provides an electrical conductor for connection to a component input of the type which by-passes the component to connect with another component in which the conductor incorporates a break in the conducting path and in which the two ends of the break are connected to the input at physically separate locations for conduction between them across the component input. This ensures that all the current will flow through the component. This can be particularly important when the component has a very impedance.

Ideally, the conductor incorporates the break where it contacts the input. This is particularly advantageous and is a very easy way of providing the necessary conductor and preferably the conductor forms a flat metal conductor where it contacts the component input and in many instances can be formed on a printed circuit board. Needless to say printed circuit boards are one of the areas where there are a large number of components and therefore the invention will be adapted to printed circuit boards and will be particularly suitable since the connectors can be readily easily made without any disruption in the printed circuit board manufacturing techniques.

Ideally the invention is adapted to high frequency applications and preferably, these are above 20 KHz. The problem, as everybody is aware, is that at high frequencies noises are introduced into the circuit and it becomes very important to eliminate these noises.

Preferably, insulation material is introduced in the break between the ends. This will obviously be easier to achieve in printed circuit boards, but may also be achieved in other situations.

It is also envisaged that the electrical conductor will be used with certain components, particularly capacitors and filters which are often used for high frequency operations.

It is also envisaged that the conductor according to the present invention will be used with a four terminal connection component, or with an assembly of a circuit and a sub-circuit where the circuits are connected by an electrical conductor.

Finally it is envisaged that the present invention will be particularly applicable to switch mode power supply converters.

## Detailed Description of the Invention

The invention will be more clearly understood from the following description of some embodiments thereof, given by way of example only described with reference to the accompanying drawings in which:

Fig. 1 is a schematic diagram of a prior art conductor;

Fig. 2 is a perspective view of a conductor in accordance with the invention;

Figs. 3(a) to (d) are plan views of printed circuit board conductors and components of both the prior art and the invention;

Figs. 4(a) and (b) are typical representations of the circuits of Fig. 3;

Figs. 5(a) and (b) illustrate the input and output of a typical application of a DC to DC converter; and

Figs. 6(a) and (b) are physical and electrical representations of a four terminal connection to a component and conductor according to the invention.

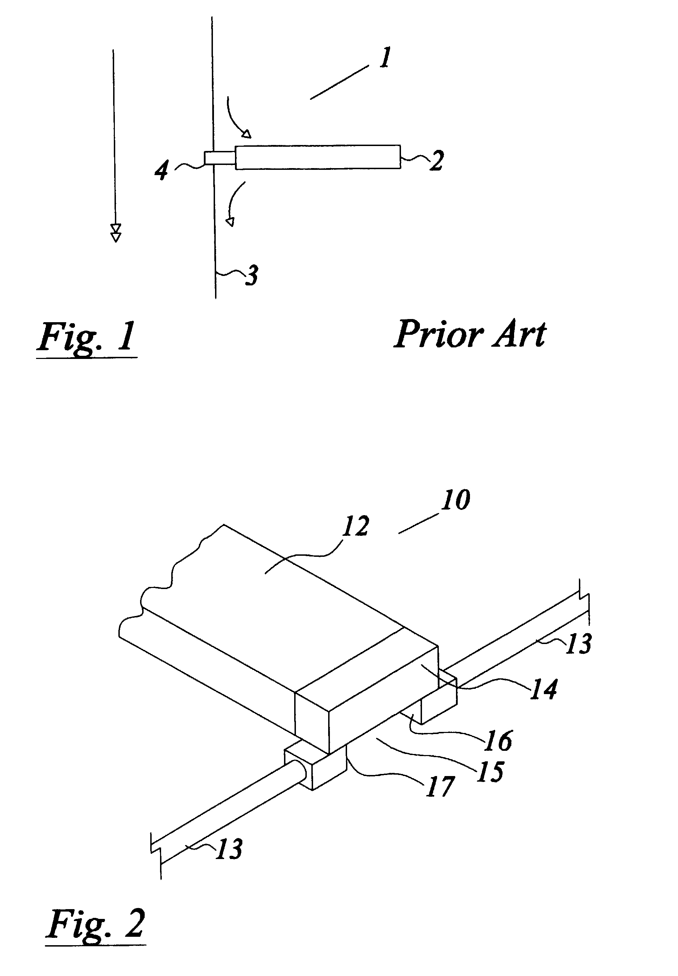

Referring to the drawings and initially to Fig. 1, there is illustrated portion of an assembly of component and conductor indicated generally by the reference numeral 1. In this case, portion of a capacitor 2 is illustrated mounted on a straight through metal conductor 3, the connection is made at a node 4 in any conventional manner such as soldering. The capacitor 2 will also be connected to another conductor, not shown depending on the circuit. This is the standard way in which components are connected to conductors which by-pass the component for connection with another component or components.

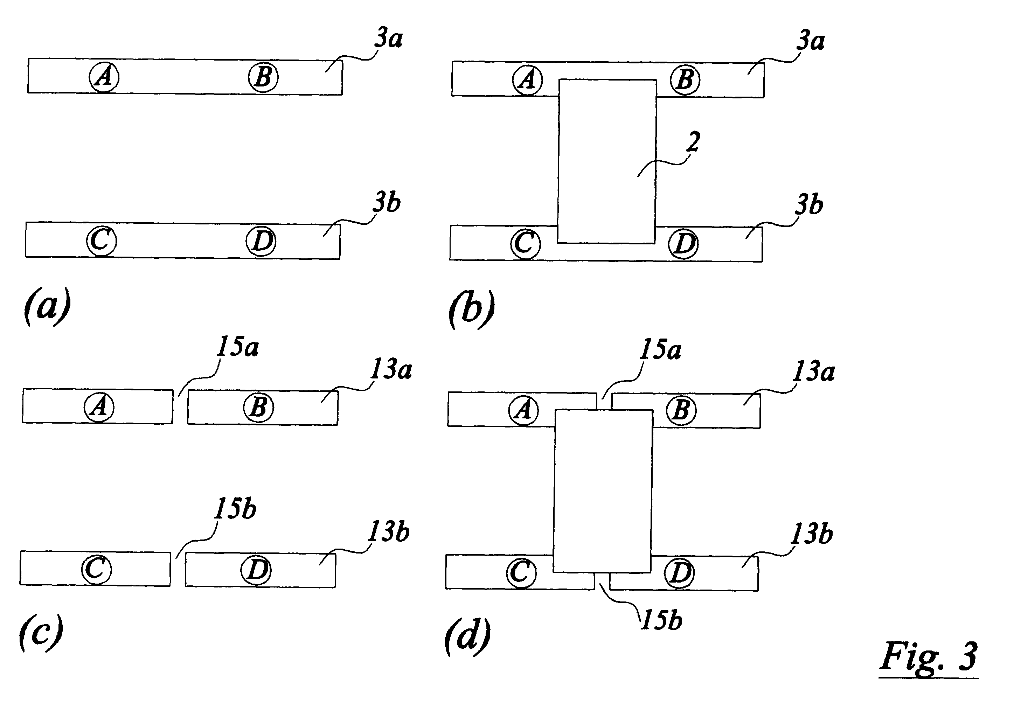

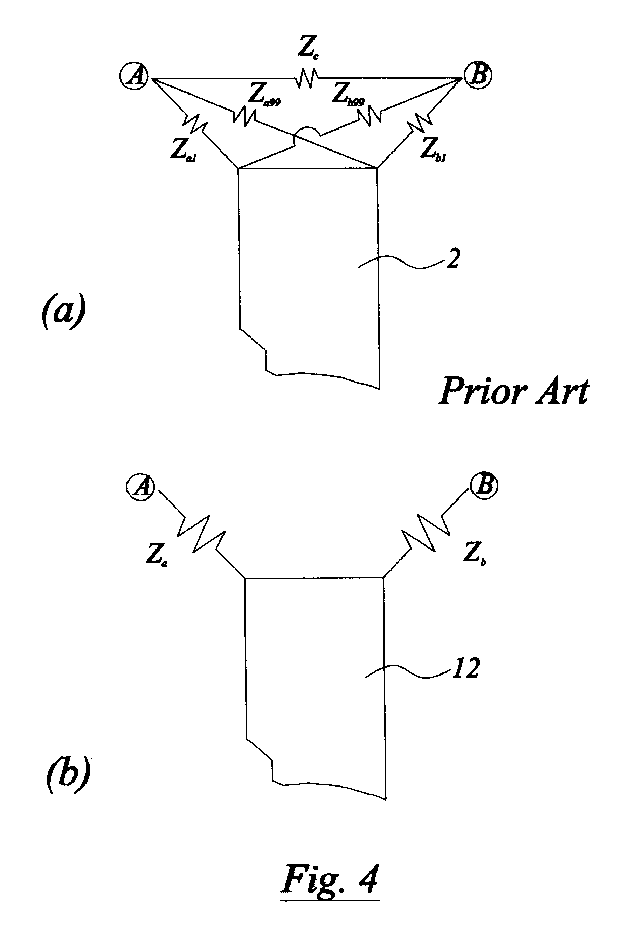

Referring now specifically to Figs. 3(a) and (b) and Fig. 4(a), there is illustrated the capacitor 2 mounted between two conductors 3a and 3b on a printed circuit board. The points A, B, C and D on the conductors 3a and 3b are identified.

Referring to Fig. 4(a), it will be appreciated that there will be an impedance between A and B along the conductor 3a, which impedance can be represented by $Z_c$. There will also be impedance between the whole of the capacitor 2 and the point A on the conductor 3a, which is represented by $Z_{a1}$ to $Z_{a99}$ being a distributed impedance across the capacitor input. Only $Z_{a1}$ and $Z_{a99}$ are shown to avoid confusion. The impedance is strictly

$$\sum_{a=99}^{a=1} Z_a$$

and similarly, there will be an impedance between the capacitor 2 and the portion of the conductor at B, namely impedance $Z_{b1}$ to $Z_{b99}$. As can be seen clearly the current paths cross between the two sides. Some current is by-passed and there is a common impedance formed between the two sides which is disadvantageous. This becomes increasingly important as the impedance of the capacitor reduces.

Referring now to Fig. 2 and again to Figs. 3(c) and (d) and Fig. 4(a), there is illustrated an assembly of conductor, according to the invention and a component indicated generally by the reference numeral 10. This assembly 10 comprises another capacitor 12 mounted on a conductor 13 by a connection 14. The conductor 13 incorporates a break 15 having first and second ends 16 and 17 where it contacts the connection 14 which acts as the input for the capacitor 12. Thus, current shown by the arrows will flow in the conductor 13 to the end 16 into the input formed by the connection 14, across the connection 14 and into the other end 17 of the break 15.

Referring now to Figs. 3(c) and (d), the conductors 13a and 13b are shown with breaks 15a and 15b on a printed circuit board. Fig. 3(d) illustrates the capacitor 12 mounted between the conductors 13a and 13b. Fig. 4(b) now shows that the only impedances involved are $Z_a$ and $Z_b$ as the impedance $Z_c$ and all other impedances has been eliminated. All the current now has to flow into the capacitor 12.

For example, a typical capacitor would be a solid pantalum chip capacitor type 594D as sold under the Trade Mark TANTAMOUNT by Vishay Sprague Limited. For example, such a capacitor has a capacitance range of 1.0 µF to 1000 µF and an equivalent series resistance measured at 100 KHz of 3500 milliohms to 30 milliohms operating effectively at room temperature.

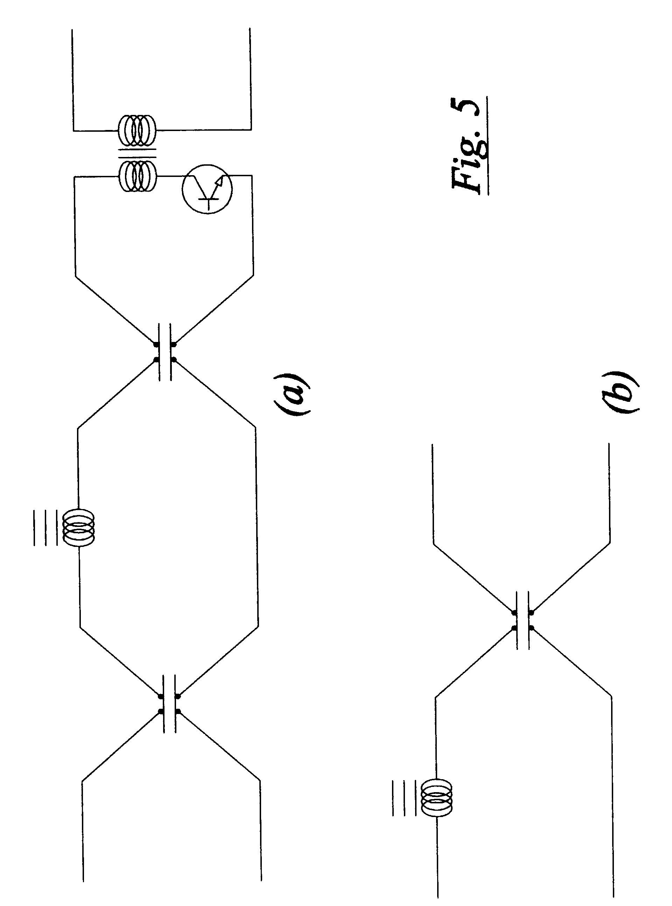

Referring specifically to Figs. 5(a) and (b), there is shown a typical example of the input (in Fig. 5(a)) and the output (Fig. 5(b)) of a 10 watt DC/DC converter. Referring now to Fig. 5(a) at the input the DC input would usually have a maximum of 40 µA of AC current, while the switching element, for example a MOSFET as illustrated would switch a 1 amp current at 500 KHz. The capacitors and their connection in accordance with the invention is illustrated by Vee connections so as to demonstrate the separated connections.

Referring now to Fig. 5(b) at the output circuit by this stage, there could be up to 400 milliamps of AC current superimposed on the DC current, thus the current ratio between input and immediately prior to output is of the order of:

$$\frac{400 \text{ mA}}{40 \text{ }\mu\text{A}} = 10,000:1$$

Thus, any coupling between the input current and the output current is to be avoided. By using the present connections, it has been found that in situations such as this between 10 and 20% of the output ripple has been eliminated, because all the current is going through the various filter components, whether they be capacitors or inductors and not being by-passed directly onwards.

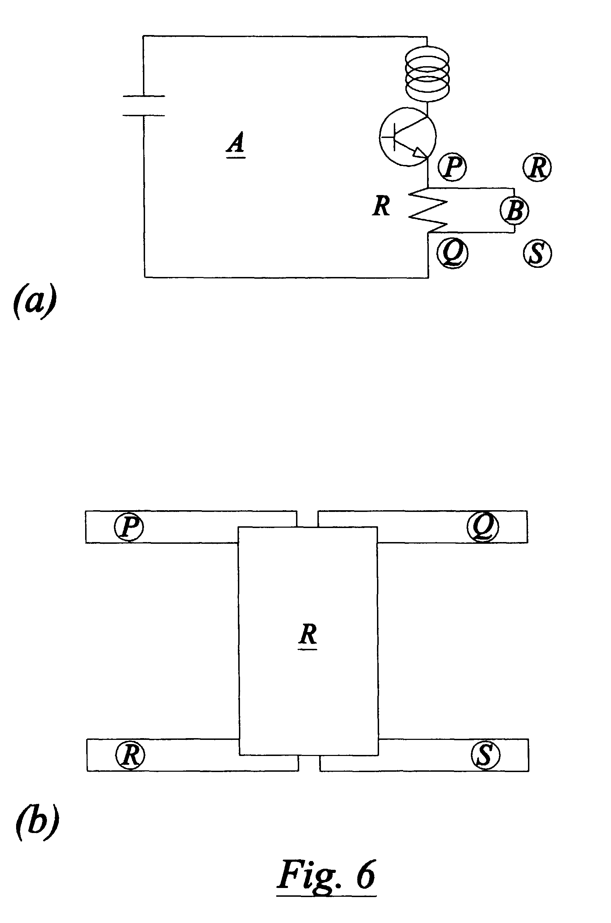

Referring to Fig. 6(a) there is illustrated a prior art situation where voltage drop across the impedance R in a circuit A fed to the measuring circuit B to measure the switched current. The problem in this circuit is to separate the voltages developed across the connection impedance ($Z_{a1}$ to $Z_{a99}$ $Z_{b1}$ to $Z_{b99}$ and $Z_c$ in Fig. 4) and to prevent these affecting the measuring circuit as explained above. With connections as illustrated in Fig. 6 (b) which are in accordance with the invention common impedance in the connections between the circuits A and B are eliminated. The points on the conductors are identified by the letters PQRS in both Fig. 6(a) and 6(b).

While in the embodiments described above, it has been described with reference to capacitors, it will be appreciated that any component could be used where similar considerations of impedance apply. It will also be appreciated that with the four terminal connection it is possible to eliminate the noise of the connections from the measurement and thus to ensure that the measurement of the load is as accurate as possible. Further it will allow more accurate measurement of load current and hence tighter control parameters can be achieved, with subsequent cost savings.

It will also be appreciated that the problems outlined in this specification for which we propose a solution are important at all frequencies including DC current, but are particularly important at high frequencies.

While the embodiments described above have related largely to switch mode power supplies, it will be readily appreciated that the invention can be applied to other components and other conductors and is not for example limited to printed circuit board conductors.

Further, as mentioned above, it is envisaged that the conductor will be printed on a printed circuit board.

It will be appreciated that while in the embodiments described above the conductors have been shown as straight parallel tracks on a printed circuit board that they could be arranged as tracks in any orientation.

While only one type of solid conductor has been illustrated in Fig. 2, it will be appreciated that many other types of conductors can be used. The essential feature of the invention being the break in the conductor where it contacts the component input. Essentially the invention requires that there is a break in the conducting path provided by the conductor to define first and second separate ends in the connecting path or the conductor as will be the more common construction. The invention then requires some means for connecting the first end to the component input at a first location and the second end to another second location on the component input with the two locations being physically separate so that there is a conduction path formed between the first and second ends which includes part of the component between the two locations. Generally the arrangement will be somewhat as shown in this specification, but not necessarily as those skilled in the art will quickly devise other ways of carrying out the invention.

Ideally, there is an insulation material in the break between the ends of the conductor. Obviously the break should be as small as possible, while at the same time not causing current to flow across it.

In the specification the terms "comprise, comprises, comprised and comprising" or any variation thereof and the terms "include, includes, included and including" or any variation thereof are considered to be totally interchangeable and they should all be afforded the widest possible interpretation and vice versa.

The invention is not limited to the embodiment hereinbefore described, but may be varied in both construction and detail within the scope of the claims.

## Claims

1.    An electrical conductor (13) for connection to a component input (14) of the type which by-passes the component (12) to connect with another component characterised in that the conductor (13) incorporates a break (15) in the conducting path and in which the two ends (16, 17) of the break are connected to the input at physically separate locations for conduction between them across the component input (14).

2.    An electrical conductor (13) as claimed in claim 1 in which the conductor (13) incorporates the break (15) where it contacts the component input (14).

3.    An electrical conductor (13) as claimed in claim 1 or 2 in which the conductor (13) forms a flat metal conductor where it contacts the component input (14).

4.    An electrical conductor (13) as claimed in any preceding claim in which the conductor (13) is formed on a printed circuit board.

5.    An electrical conductor (13) as claimed in any preceding claim for high frequency applications.

6.    An electrical conductor (13) as claimed in claim 5 in which the frequency exceeds 20 KHz.

7.  An electrical conductor (13) as claimed in any preceding claim in which there is insulation material in the break (15) between the ends (16, 17).

8.  An assembly of an electrical conductor (13) as claimed in any of claims 1 to 7 and a capacitor (12).

9.  An assembly of an electrical conductor (13) as claimed in any of claims 1 to 7 and a filter.

10. An assembly of an electrical conductor (13) as claimed in any of claims 1 to 7 and a four terminal connection component.

11. An assembly of a circuit and a sub-circuit where the circuits are connected by the electrical conductor (13) as claimed in any of claims 1 to 7.

12. An assembly as claimed in any of claims 8 to 11 comprising a switch mode power supply converter.

*Fig. 1*                    *Prior Art*

*Fig. 2*

Fig. 3

$(a)$

Prior Art

$(b)$

**Fig. 4**

*(a)*

*(b)*

*Fig. 5*

EP 0 973 363 A1

(a)

(b)

Fig. 6

European Patent Office

**EUROPEAN SEARCH REPORT**

Application Number

EP 99 65 0062

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.7) |
| X | GB 2 272 108 A (SMITHS INDUSTRIES PUBLIC LIMITED COMPANY) 4 May 1994 (1994-05-04) * the whole document * | 1-6,8, 10,11 | H05K1/11 H05K1/02 |
| X | PATENT ABSTRACTS OF JAPAN vol. 96, no. 01, 31 January 1996 (1996-01-31) -& JP 07 249844 A (PFU), 26 September 1995 (1995-09-26) * abstract * | 1-6,8,11 | |
| X | PATENT ABSTRACTS OF JAPAN vol. 17, no. 418 (E-1408), 4 August 1993 (1993-08-04) -& JP 05 082936 A (TAMURA SEISAKUSHO CO), 2 April 1993 (1993-04-02) * abstract * | 1-5,8, 10,11 | |
| X | PATENT ABSTRACTS OF JAPAN vol. 98, no. 10, 31 August 1998 (1998-08-31) -& JP 10 145015 A (SUMITOMO WIRING SYST), 29 May 1998 (1998-05-29) * abstract * | 1-4,8, 10,11 | TECHNICAL FIELDS SEARCHED (Int.Cl.7) H05K |
| X | PATENT ABSTRACTS OF JAPAN vol. 95, no. 10, 30 November 1995 (1995-11-30) -& JP 07 183627 A (ROHM CO), 21 July 1995 (1995-07-21) * abstract * | 1-4,7, 10,11 | |
| X | PATENT ABSTRACTS OF JAPAN vol. 17, no. 453 (E-1417), 19 August 1993 (1993-08-19) -& JP 05 102621 A (NIPPON CHEMICON CORP), 23 April 1993 (1993-04-23) * abstract * | 1-4,7, 10,11 | |

The present search report has been drawn up for all claims

| Place of search | Date of completion of the search | Examiner |
|---|---|---|
| THE HAGUE | 29 October 1999 | Mes, L |

EPO FORM 1503 03.82 (P04C01)

## ANNEX TO THE EUROPEAN SEARCH REPORT
## ON EUROPEAN PATENT APPLICATION NO.

EP 99 65 0062

This annex lists the patent family members relating to the patent documents cited in the above–mentioned European search report.
The members are as contained in the European Patent Office EDP file on
The European Patent Office is in no way liable for these particulars which are merely given for the purpose of information.

29–10–1999

| Patent document cited in search report | | Publication date | Patent family member(s) | | Publication date |
|---|---|---|---|---|---|
| GB 2272108 | A | 04-05-1994 | DE 4336727 A<br>FR 2697714 A<br>US 5379189 A | | 05-05-1994<br>06-05-1994<br>03-01-1995 |
| JP 07249844 | A | 26-09-1995 | JP 2882994 B | | 19-04-1999 |
| JP 05082936 | A | 02-04-1993 | NONE | | |
| JP 10145015 | A | 29-05-1998 | NONE | | |
| JP 07183627 | A | 21-07-1995 | NONE | | |
| JP 05102621 | A | 23-04-1993 | NONE | | |

EPO FORM P0459